# EUROPEAN PATENT SPECIFICATION

(11) **EP 4 584 598 B1**
(45) Date of publication and mention of the grant of the patent: **04.11.2026**
(21) Application number: 23794128.1
(22) Date of filing: 22.09.2023
(51) Int. Cl.: G01R 21/01

(54) **LOW-POWER INTEGRATED RADIO FREQUENCY POWER DETECTOR**
INTEGRIERTER HOCHFREQUENZLEISTUNGSDETEKTOR MIT NIEDRIGER LEISTUNG
DÉTECTEUR DE PUISSANCE RADIOFRÉQUENCE INTÉGRÉ À FAIBLE PUISSANCE

(30) Priority: 23.09.2022 US 202263409212 P
(43) Date of publication of application: 16.07.2025
(60) Divisional application: 26201494.7 / 4 822 361
(73) Proprietor: ViaSat, Inc., Carlsbad, CA 92009 (US)
(72) Inventor: COPELAND, David, Carlsbad, CA 92009 (US)
(74) Representative: Swindell & Pearson Limited
(86) International application number: PCT/US2023/033521
(87) International publication number: WO 2024/064365

(56) References cited:
- CN-A- 113 640 576
- US-B1- 8 422 970
- KENNETH A TOWNSEND ET AL: "A Wideband Power Detection System Optimized for the UWB Spectrum", IEEE JOURNAL OF SOLID-STATE CIRCUITS, IEEE, USA, vol. 44, no. 2, 1 February 2009 (2009-02-01), pages 371 - 381, XP011243163, ISSN: 0018-9200, DOI: 10.1109/JSSC.2008.2011032
- WU GE ET AL: "A 65 nm CMOS broadband self-calibrated power detector for the square kilometre array radio telescope", THE JOURNAL OF ENGINEERING, THE INSTITUTION OF ENGINEERING AND TECHNOLOGY, MICHAEL FARADAY HOUSE, SIX HILLS WAY, STEVENAGE, HERTS. SG1 2AY, UK, vol. 2014, no. 8, 1 August 2014 (2014-08-01), pages 494 - 502, XP006068453, DOI: 10.1049/JOE.2014.0164

## Description

### BACKGROUND

The following relates generally to communications, including radio frequency (RF) power detectors. Some communications devices may communicate with one another using wireless (e.g., RF) connections, such as in satellite communication systems. Satellites in satellite communication systems may implement circuitry to down convert signals in one band received on an uplink to the satellite to a second band for transmitting on the downlink to the other communication devices in the satellite communication systems. These down-converter circuits may be subject to temperature variations, power fluctuations, and other hazards of the space environment. As such, the down-converter circuits may need to be robust and lightweight, and it may be desirable that their response be stable over environmental conditions such as temperature, as calibration opportunities may be limited.

US 8,422,970 B1 discloses a circuit configured to receive an input signal and to produce an output signal measuring a power of the input signal.

CN 113 640 576 A discloses a radio frequency power detection circuit.

"A Wideband Power Detection System Optimized for the UWB Spectrum" by Kenneth Townsend et al in the IEEE Journal of Solid-State Circuits, IEEE, USA, vol. 44 no.2, 1 February 2009, pages 371-381, discloses a wideband radio-frequency power detection system.

"A 65nm CMOS broadband self-calibrated power detector for the square kilometre array radio telescope" by Wu Ge et al from The Journal of Engineering, The Institution of Engineering and Technology, vol. 2014, no. 8, 1 August 2014, pages 494-502, discloses a 65 nm complementary metal oxide semiconductor (CMOS) broadband self-calibrated high-sensitivity power detector.

### SUMMARY

The described techniques relate to improved methods, systems, devices, and apparatuses that support low-power integrated radio frequency power detection. For example, the described techniques provide for an RF power detector that outputs a linear-to-dB voltage based on differential RF input signals with limited temperature sensitivity. The RF power detector includes a rectifier that has multiple rectifier cores (also referred to as rectifier stages). In some cases, one or more of the rectifier cores are self-biased (e.g., the current sources may be diode connected and be independent of external bias voltages for setting a bias current for the rectifier core). The rectifier cores may have components that match one or more parameters with similar components of the other rectifier cores. One or more of the rectifier cores may provide an output current that is proportional to a difference between a differential input rectifier core and a common mode input rectifier core. The RF power detector may include a logarithmic amplifier stage. The RF power detector may be used in any application where sampling a power signal from an RF input signal is used.

### BRIEF DESCRIPTION OF THE DRAWINGS

FIG. 1 shows an example of a satellite communication system that supports low-power integrated radio frequency power detection in accordance with aspects of the present disclosure.
FIG. 2 shows an example of an RF power detector that supports low-power integrated radio frequency power detection in accordance with aspects of the present disclosure.
FIG. 3 shows an example of a rectifier core that supports low-power integrated radio frequency power detection in accordance with aspects of the present disclosure.
FIG. 4 shows an example of a rectifier that supports low-power integrated radio frequency power detection in accordance with aspects of the present disclosure.
FIG. 5 shows an example of a rectifier that supports low-power integrated radio frequency power detection in accordance with aspects of the present disclosure.
FIG. 6 shows an example of a scaling circuit that supports low-power integrated radio frequency power detection in accordance with aspects of the present disclosure.
FIG. 7 shows a flowchart illustrating methods that support low-power integrated radio frequency power detection in accordance with aspects of the present disclosure.

### DETAILED DESCRIPTION

Satellite communication systems may employ down converters to convert from one radio frequency (RF) band to another. For example, a satellite may need to convert radio frequency signals in a first band (e.g., Ka-band) to a second band (e.g., K-band), which may entail stepping down the frequency of the received radio signal. To perform the down conversion, a down conversion mixer may be located on board the satellite. The down conversion mixer may use a local oscillator (LO) that may be controlled via an RF power control loop that includes a power detector for maintaining consistent LO power. Additionally, or alternatively, power detectors may be used to detect the power of received RF signals or transmitted RF signals prior to or after the down conversion. The RF power detector may detect RF power of the LO signals, received RF signals, or transmitted RF signals, and convert the rectifier output (e.g., a current) to a voltage. The RF power detector may scale the voltage to an appropriate range (e.g., a range of an analog-to-digital converter (ADC)).

However, conventional down conversion mixers may generate spurious tones that can result in noise or other errors in the converted signal. Satellite communication systems may have strict spurious tone requirements for the given frequency (e.g., the specific frequency plan for the specific satellite). Thus, reduction of spurious tones added to the band of the satellite's conversion bandwidth by the down conversion mixer may be desired. Techniques and apparatuses described herein reduce the spurious tones that are traditionally present due to the functionality of a down conversion mixer.

Techniques described enable LO power to be controlled to a high degree in an LO power detector control loop. The power detector converts the power of a signal into a digital form so that a state machine can close the power control loop within temperature and resolution performance requirements set by the satellite communication system. The LO power detector converts RF signal power of an input RF signal to a linear-in-dB voltage.

Techniques and apparatuses described herein demonstrate an LO power detector (referred to herein as an RF power detector) with a rectifier that has multiple rectifier cores. At least some of the rectifier cores may be self-biased (e.g., may not have bias currents set by external bias voltages). For example, at least some of the rectifier cores may have diode connected bias transistors and the bias current may be a function of the transistor parameters (e.g., transistor size), the quantity of cascaded transistors, and a supply voltage level. Transistors of the rectifier cores may thus have bias points set by diode current curves, and may not have bias currents set by application of a reference voltage. One or more of the rectifier cores may provide an output current that is proportional to a difference between a differential input rectifier core and a common mode input rectifier core. The RF power detector may include a logarithmic amplifier stage. This configuration may provide enhanced control of the local oscillator input power level into the down conversion mixer, which may nearly eliminate the spurious tones.

In some cases, the RF power detector includes four rectifier cores. The first rectifier core may perform rectification on the RF input signal, which is inputted to the RF power detector as a differential signal. The second rectifier core may have a current proportional to a common mode of the differential signal. The third rectifier core may output a reference voltage that is based on the bias voltage (e.g., DC bias) of the RF power detector RF input signal. The fourth rectifier core may output an output current for the RF power detector based on the outputs of other rectifier cores. The output current may be the difference between the current of the first rectifier core (e.g., which may be proportional to the power of the differential inputs of the RF input signal) and the current of the second rectifier core (e.g., which may be proportional to the common mode of the differential inputs of the RF input signal). The RF power detector may include a logarithmic amplifier stage which may output a voltage that may be a logarithmic function of the difference between the reference voltage output by the third rectifier core and the current output by the fourth rectifier core. The output current of the RF power detector may thus be proportional to the actual RF input power, where the deleterious effects that happen due to the operation of the circuitry and temperature variations are compensated.

The various components of the RF power detector may be matched with each other (e.g., little variation on the parameters of the similar components), which improves the control of the local oscillator input power. When the components are matched and transistors in the rectifier cores are allowed to draw a self-biased current, then the rectifier cores track each other, mitigating temperature effects.

The techniques and apparatuses described herein provide improved functionality of an RF power detector, while the RF power detector is lightweight and low power. The RF power detector may also be capable of functioning for the duration of its life with limited calibration (e.g., only a single initial calibration). The RF power detector according to techniques described herein is largely temperature insensitive.

Aspects of the disclosure are initially described in the context of satellite communication systems. Aspects of the disclosure are further illustrated by and described with reference to apparatus diagrams, circuit diagrams, system diagrams, block diagrams, and flowcharts that relate to a low-power integrated radio frequency power detector.

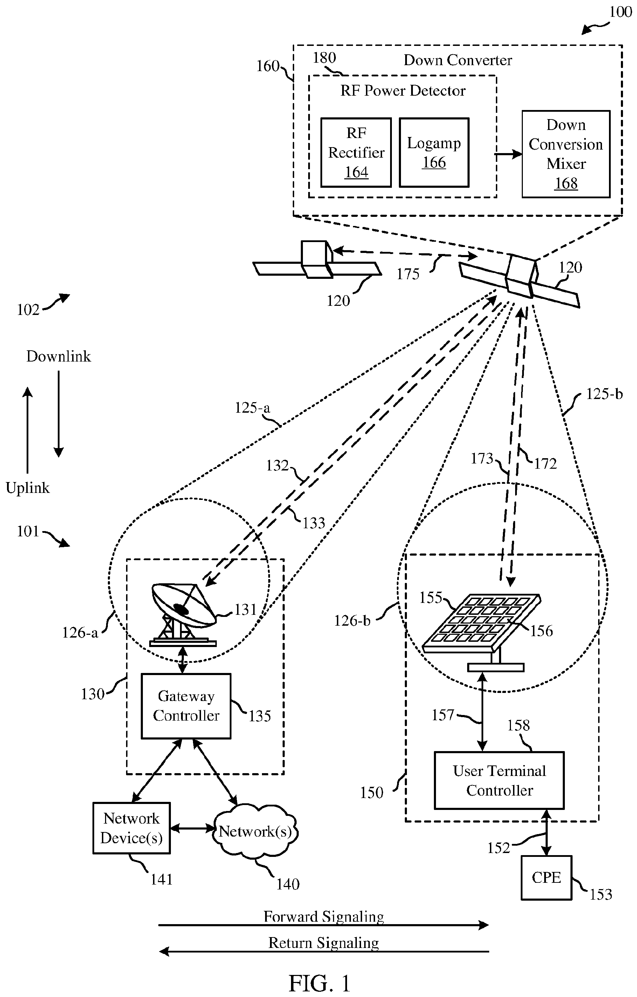

**FIG.** 1 shows a diagram of a communication system 100 (e.g., a satellite communication system) that supports techniques for a low-power integrated radio frequency power detector in accordance with examples as disclosed herein. A communication system 100 may use various architectures to support a communication service, such as an architecture that includes a ground segment 101 and space segment 102. A space segment 101 may include one or more satellites 120 (e.g., communications satellites). A ground segment 102 may include ground terminals, such as one or more user terminals 150 (e.g., service consumer terminals) and one or more gateway terminals 130 (e.g., access node terminals, network terminals, service provider terminals), as well as network devices 141 such as network operations centers (NOCs), and satellite and gateway terminal command centers. In some implementations, terminals of the communication system 100 (e.g., gateway terminals 130) may be communicatively coupled with each other, or with one or more networks 140, or a combination thereof (e.g., via a mesh network, via a star network, via a wired network, via a wireless network).

Satellites 120 may include any suitable type of satellite configured for wireless communication (e.g., for providing a communication service) with or between gateway terminals 130 and user terminals 150. In some examples, one or more of the satellites 120 (e.g., all of the satellites 120) may be in a geostationary (GEO) orbit, or a respective orbit for which a position of the satellite 120 relative to the earth changes over time (e.g., a non-geostationary orbit (NGSO), such as a low Earth orbit (LEO) or medium Earth orbit (MEO)). Although certain techniques and apparatus are described herein with reference to a satellite 120 being an example of a device that relays communications between ground terminals, one or more techniques or apparatus described herein may be applicable to other types of devices operable to relay signaling (e.g., between ground terminals), which may have a generally overhead location relative to ground terminals (e.g., a plane, an unmanned aerial vehicle, a drone, a dirigible), or may be ground-based relays, including mobile or stationary relay devices.

The communication system 100 may support uplink signaling (e.g., from the ground segment 101 to the space segment 102), downlink signaling (e.g., from the space segment 102 to the ground segment 101), crosslink signaling (e.g., between devices of the space segment 102, such as between satellites 120), or any combination thereof. The communication system 100 also may support forward signaling (e.g., from gateway terminals 130 to user terminals 150), return signaling (e.g., from user terminals 150 to gateway terminals 130), among other signaling (e.g., signaling between gateway terminals 130, signaling between user terminals 150) or any combination thereof. For example, a satellite 120 may receive forward uplink signals 132 from one or more gateway terminals 130, and also may transmit forward downlink signals 172 to one or more user terminals 150. Additionally, or alternatively, a satellite 120 may receive return uplink signals 173 from one or more user terminals 150, and also may transmit return downlink signals 133 to one or more gateway terminals 130. Additionally, or alternatively, a first satellite 120 may transmit crosslink signaling 175 that may be received by a second satellite 120.

Various physical layer modulation and coding techniques may be supported for the communication of signals between gateway terminals 130 and user terminals 150 (e.g., via one or more satellites 120), such as multi-frequency time-division multiple access (MF-TDMA), time division multiple access (TDMA), frequency division multiple access (FDMA), orthogonal frequency division multiple access (OFDMA), code division multiple access (CDMA), or any number of hybrid or other schemes known in the art. In various embodiments, physical layer techniques may be the same for each of the signals 132, 133, 172, 173, and 175, or some of the signals may use different physical layer techniques than other signals. A satellite 120 may support communications using one or more frequency bands, and any number of subbands thereof. For example, the satellite 120 may support operations in the International Telecommunications Union (ITU) Ku, K, or Ka-bands, C-band, X-band, S-band, L-band, V-band, among others. For example, the satellite 120 may support operations in any combination of bands, such as the K band and the Ka-band, or any other combination of bands.

A satellite 120 may include a system of one or more antennas (e.g., one or more antenna systems), such as a phased array antenna, a phased array fed reflector (PAFR) antenna, or any other mechanism known in the art for transmission and/or reception of signals of a communication service. In some examples, an antenna system may support communication via one or more beamformed spot beams 125, which may be referred to as beams, service beams, satellite beams, or any other suitable terminology. Signals may be passed via an antenna system of a satellite 120 to form the spatial electromagnetic radiation pattern of the spot beams 125. In some examples, a spot beam 125 may use or be otherwise associated with a single carrier (e.g., one frequency or a contiguous frequency range).

In some examples, a spot beam 125 may be configured to support only gateway terminals 130 (e.g., a single gateway terminal 130), in which case the spot beam 125 may be referred to as a gateway spot beam or a gateway beam (e.g., a gateway spot beam 125-a). For example, the gateway spot beam 125-a may be configured to support one or more forward uplink signals 132 and/or one or more return downlink signals 133 between the satellite 120 and a gateway terminal 130. In some examples, a satellite 120 may support a first gateway spot beam 125 (e.g., an uplink gateway spot beam, a forward gateway spot beam) for forward uplink signals 132 (e.g., to output a forward uplink beam signal), and may support a second gateway spot beam 125 (e.g., a downlink gateway spot beam, a return gateway spot beam, etc.) for return downlink signals 133 (e.g., to obtain a return downlink beam signal). In various examples, such techniques may include gateway beams that are aligned along different directions from a satellite 120 (e.g., toward different gateways for forward and return traffic), or supported via different antenna systems (e.g., a reception antenna system and a transmission antenna system) or portions thereof of a satellite 120, or both.

In some examples, a spot beam 125 may be configured to support only user terminals 150 (e.g., one or more user terminals 150), in which case the spot beam 125 may be referred to as a user spot beam or a user beam (e.g., user spot beam 125-b). For example, a user spot beam 125-b may be configured to support one or more forward downlink signals 172 and/or one or more return uplink signals 173 between the satellite 120 and user terminals 150. In some examples, a satellite 120 may support a first user spot beam 125 (e.g., a downlink user spot beam, a forward user spot beam) for forward downlink signals 172 (e.g., to output a forward downlink beam signal), and may support a second user spot beam 125 (e.g., an uplink user spot beam, a return user spot beam, etc.) for return uplink signals 173 (e.g., to obtain a return uplink beam signal). In various examples, such techniques may include user beams aligned along different directions from a satellite 120 (e.g., toward different portions of a service area), or supported via different antenna systems (e.g., a transmission antenna system and a reception antenna system) or portions thereof of a satellite 120, or both.

In some examples, a spot beam 125 may be configured to service both user terminals 150 and gateway terminals 130. For example, a spot beam 125 may be configured to support any combination of forward downlink signals 172, return uplink signals 173, forward uplink signals 132, or return downlink signals 133 between a satellite 120 and user terminals 150 and gateway terminals 130. In some examples, a satellite 120 may use a spot beam 125 for transmitting crosslink signals 175, or for receiving crosslink signals 175, or both (e.g., using a same crosslink spot beam for transmitting and receiving crosslink signals 175, using a first crosslink spot beam for transmitting crosslink signals 175 and a second crosslink spot beam for receiving crosslink signals 175, which may be supported by a same antenna systems or different antenna systems).

A spot beam 125 may support a communication service with target devices (e.g., user terminals 150, gateway terminals 130, satellites 120) that are located within a spot beam coverage area 126, or projection thereof (e.g., at different distances from a plane or surface of the spot beam coverage area 126). A spot beam coverage area 126 may be defined by an area of the electromagnetic radiation pattern of the associated spot beam 125, as projected on the ground or other reference surface, having a signal characteristic (e.g., signal strength, signal-to-noise ratio (SNR), signal-to-interference-plus-noise ratio (SINR)) that is above or otherwise satisfies a threshold. A spot beam coverage area 126 may cover any suitable service area (e.g., circular, elliptical, hexagonal, local, regional, national, planar, non-planar) and may support a communication service with any quantity of target devices located in the spot beam coverage area 126, which may include target devices located within the associated spot beam 125, but not necessarily at the reference surface of a spot beam coverage area 126, such as airborne terminals or underwater terminals.

In some examples, a satellite 120 may support multiple beamformed spot beams 125 each covering respective spot beam coverage areas 126, each of which may or may not overlap with adjacent spot beam coverage areas 126. For example, the satellite 120 may support one or more service areas (e.g., service coverage areas) using any quantity of spot beam coverage areas 126. A service area may be broadly defined as a coverage area from which, and/or to which, either a terrestrial transmission source, or a terrestrial receiver may participate in (e.g., transmit and/or receive signals associated with) a communication service via one or more satellite 120, and may be served by a plurality of spot beam coverage areas 126 via one or more satellites 120 (e.g., for a respective durations during which a satellite 120 in an NGSO is able to serve one or more spot beam coverage areas 126 that are at least partially overlapping with the service area). In some systems, the service coverage area for each communications link (e.g., a forward uplink coverage area, a forward downlink coverage area, a return uplink coverage area, and/or a return downlink coverage area) may be different. In FIG. 1, a spot beam coverage areas 126 may include a spot beam coverage areas 126-a that covers the gateway terminal 130 and a spot beam coverage areas 126-b that covers the user terminal.

User terminals 150 may include any number of devices configured to communicate signals with a satellite 120, or other target device, which may include fixed terminals (e.g., ground-based stationary terminals) or mobile terminals (e.g., terminals on boats, terminals on aircraft, terminals on ground-based vehicles, and the like), among other types of terminals. A user terminal 150 may communicate data and information via the satellite 120 or other target device, which may include communications via a gateway terminal 130 to a destination device such as a network device 141, or some other device or distributed server associated with a network 140. A user terminal 150 may communicate signals according to a variety of physical layer transmission modulation and coding techniques, including, for example, those defined with the DVB-S2, WiMAX, LTE, and DOCSIS standards.

A user terminal 150 may include an antenna 155 that is configured for receiving forward downlink signals 172 (e.g., from a satellite 120), for transmitting return uplink signals 173 (e.g., to a satellite 120), or both. In some examples, a user terminal 150 may be configured for uni-directional or bi-directional communications with the satellite 120 via a spot beam 125 (e.g., user spot beam 125-b). In some implementations, an antenna 155 may include an array (e.g., a two-dimensional array, a phased array) of feed elements 156 that are physically arranged in a feed array assembly, and signals of respective feed elements 156 may be manipulated according to various beamforming techniques (e.g., phase and/or amplitude manipulation) to support terminal spot beams (not shown), such as transmit beams (e.g., for directional transmission) and receive beams (e.g., for directional reception). In other words, communication via an antenna 155 may be electronically configurable using the array of feed elements 156 to align signal transmission and/or reception along a desired direction (e.g., a terminal spot beam orientation). In some other implementations, a signaling direction of an antenna 155 may be mechanically configurable (e.g., mechanically steerable), or both electronically and mechanically configurable, or an antenna 155 may implement an omnidirectional antenna, among other techniques.

A user terminal 150 may be connected via a wired or wireless connection 152 to one or more instances of consumer premises equipment (CPE) 153, and may provide network access service (e.g., access to a network 140, Internet access) or other communication services (e.g., broadcast media, multicast media) to CPEs 153 via one or more devices of the communication system 100. CPEs 153 may include user devices such as, but not limited to, computers, local area networks, internet appliances, wireless networks, mobile phones, personal digital assistants (PDAs), other handheld devices, netbooks, notebook computers, tablet computers, laptops, display devices (e.g., TVs, computer monitors), printers, and the like. CPEs 153 may also include any equipment located at a premises of a subscriber, including routers, firewalls, switches, private branch exchanges (PBXs), Voice over Internet Protocol (VoIP) gateways, and the like. In some examples, the user terminal 150 provides for two-way communications between one or more CPEs 153 and one or more networks 140 (e.g., via one or more satellites 120, via one or more access node terminals 130). The antenna 155 may communicate signals 157 to a user terminal controller 158, which may coordinate with the CPE 153.

A gateway terminal 130 may service forward uplink signals 132 and return downlink signals 133 (e.g., to and from one or more satellites 120). Gateway terminals 130 may also be known as ground stations, gateways, or hubs. A gateway terminal 130 may include a gateway terminal antenna system 131 and a gateway controller 135 (e.g., an access node controller). A gateway terminal antenna system 131 may be two-way capable and designed with adequate transmit power and receive sensitivity to communicate reliably with one or more satellites 120. In some examples, a gateway terminal antenna system 131 may include a parabolic reflector with high directivity in the direction of a satellite 120 and low directivity in other directions. A gateway terminal antenna system 131 may include a variety of other configurations that support operating features such as high isolation between orthogonal polarizations, high efficiency in the operational frequency bands, low noise, and other features.

In some examples, an access node terminal 130 (e.g., an access node controller 135) may schedule traffic to user terminals 150. Additionally, or alternatively, the scheduling may be performed in other parts of communication system 100 (e.g., at one or more network devices 141, which may include network operations centers (NOC) and/or gateway command centers). A satellite 120 may communicate with an access node terminal 130 by transmitting return downlink signals 133 and/or receiving forward uplink signals 132 via one or more spot beams 125 (e.g., access node spot beam 125-b, which may be associated with a respective access node spot beam coverage area 126-b). An access node spot beam 125-b may, for example, support a communications service for one or more user terminals 150 (e.g., relayed by the satellite 120), or any other communications between the satellite 120 and the access node terminal 130.

An access node terminal 130 may provide an interface between the network 140 and the satellite 120, and may be configured to receive data and information directed between the network 140 and one or more user terminals 150. An access node terminal 130 may format the data and information for delivery to respective user terminals 150. Additionally, or alternatively, an access node terminal 130 may be configured to receive signals from the satellite 120 (e.g., from one or more user terminals 150) directed to a destination accessible via network 140. An access node terminal 130 may also format the received signals for transmission on network 140.

The network(s) 140 may be any type of network and can include, for example, the Internet, an Internet Protocol (IP) network, an intranet, a wide-area network (WAN), a metropolitan area network (MAN), a local-area network (LAN), a virtual private network (VPN), a virtual LAN (VLAN), a fiber optic network, a hybrid fiber-coax network, a cable network, a public switched telephone network (PSTN), a public switched data network (PSDN), a public land mobile network, and/or any other type of network supporting communications between devices as described herein. Network(s) 140 may include both wired and wireless connections as well as optical links. Network(s) 140 may connect the access node terminal 130 with other access node terminals that may be in communication with the satellite 120 or with other satellites. One or more network device(s) 141 may be coupled with the access node terminal 130 and may control aspects of the communication system 100. In various examples a network device 141 may be co-located or otherwise nearby the access node terminal 130, or may be a remote installation that communicates with the access node terminal 130 and/or network(s) 140 via wired and/or wireless communications link(s).

One or more of the satellites 120 may include a down converter 160, among other components. The down converter 160 may convert radio frequency signals from one band to another band. For example, the down converter 160 may convert an incoming signal from the forward uplink signal 132 on the Ka-band to the K-band to be sent via the forward downlink signals 172. In other examples, the down converter 160 may convert RF signals between different frequency bands. The down converter 160 may eliminate or nearly eliminate spurious tones that may be present at the down converter 160 (e.g., present at a mixer of the down converter 160) in the operable frequency range of the down converter 160.

The down converter 160 may include a local oscillator (LO) RF power control loop (RF power detector 180) and a down conversion mixer 168, among other components. The RF power detector 180 may be part of a complementary metal-oxide-semiconductor (CMOS) RF integrated circuit or CMOS chip. In other examples, the RF power detector 180 may be part, or all, of another type of semiconductor device or circuitry. The RF power detector 180 may provide LO power to the down conversion mixer 168. The LO power output at the RF power detector 180 may be relatively constant over temperature and the lifetime of the RF power detector 180.

RF power detector 180 may detect an RF signal input to the RF power detector 180 and may be a linear-in-decibel (dB) power detector. The RF power detector 180 may output a DC value proportional to the RF input to an analog-to-digital converter (ADC) of the down converter 160. The range for the output of the RF power detector 180 to be linear-in-dB may be only over a small range of dB, such as 10 dB. In other examples, the range for the output to be linear-in-dB may be different. In some examples, the range for the output to be linear-in-dB may be determined by the application of the device and a corresponding need. In some examples, the operational range of the RF power detector 180 may be a 10 dB range or a 20 dB range. For example, when the LO loop is initialized or converging, the range may be larger, but the LO loop may converge to a range of less than 20 dB or less than 10 dB when the LO is locked.

One or more of the satellites 120 may include a down converter 160. The down converter 160 may convert radio frequency signals from one band to another band. For example, the down converter 160 may convert an incoming signal from the forward uplink signal 132 on the Ka-band to the K-band to be sent via the forward downlink signals 172. For example, the down converter 160 may perform a down conversion of a Ka-band RF signal, for example from 27 to 31 gigahertz (GHz) to an RF signal that is 17.7 to 21.2 GHz in the K-band. The down converter 160 may include an RF power detector 180, which detects power of an RF signal such as an LO signal used for downconversion.

The RF power detector 180 may include an RF rectifier 164, which is a rectifier circuit, and one or more logarithmic amplifiers (logamps) 166. The RF rectifier 164 may output a non-linear current proportional to the RF input power. The RF rectifier 164 may include rectifier cores that are biased to mitigate temperature effects. The one or more logamps 166 may be logarithmic amplifiers. The one or more logamps 166 may convert the output current of the RF rectifier 164 into a linear-in-dB voltage. The one or more logamps 166 may be a negative-feedback, low power op-amp with a diode-connected FET in the feedback loop. The one or more logamps 166 may operate in a sub-threshold mode.

The down converter 160 may have chip power dissipation requirements that necessitate minimal DC power. The RF power detector 180 may use low power and be used in satellite applications. In contrast, an RF power detector that uses higher power may not be suitable for the application of being part of the down converter 160 on a satellite 120. An RF power detector with higher power is more heavily duty cycled to a lower overall power, which is unlikely to work in the application of the satellite 120.

The RF power detector 180 may be capable of a programmable calibration. In some examples, calibration opportunities for the RF power detector 180 may be limited (e.g., before being deployed on a satellite 120). As such, the RF power detector 180 may function well over different temperatures without any additional temperature calibrations, which can be complex, expensive, or impractical to perform or operate.

The techniques and apparatuses described herein provide improved functionality of an RF power detector, while operating at low power. In some applications, the RF power detector may always be powered on and it may be infeasible to duty cycle the RF power detector while the RF power control loop is operating. The RF power detector may be low power in order to reduce power consumption and preserve the longevity of its components.

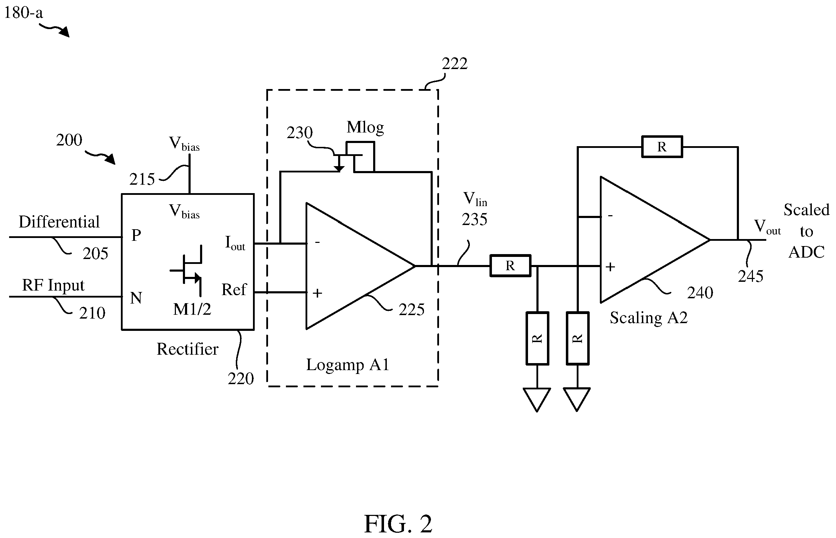

**FIG.** 2 shows an example of an RF power detector 180-a that supports low-power integrated radio frequency power detection, in accordance with examples described herein. The RF power detector 180-a may be an example of one or more aspects of the RF power detector 180 of FIG. 1. The RF power detector 180-a may be part of a down converter, such as down converter 160 of FIG. 1, that is installed on a satellite, such as satellite 120 of FIG. 1. The RF power detector 180-a may measure the power of a local oscillator coupled to the RF power detector 180-a. In examples other than FIG. 2, the RF power detector 180-a may include different or additional components compared with those shown in FIG. 2. The RF power detector 180-a may include the circuit 200.

The RF power detector 180-a may include a rectifier 220, a logamp 222, and a scaling amplifier 240. The rectifier 220 may have differential RF inputs 205 and 210. One of the differential RF inputs 205 may be input to a positive input of the rectifier 220 and the other differential RF input 210 may be input to a negative input of the rectifier 220. The differential RF inputs 205 and 210 may both be copies of the incoming RF signal, but 180 degrees out of phase with each other. The rectifier 220 may also receive a bias voltage, V_{bias} 215. The rectifier 220 includes one or more rectifier cores having differential pair input transistors, denoted as M1/2 in FIG. 2. The rectifier 220 may output Iₒᵤₜ and Ref to the logamp 222.

The logamp 222 receives output from the rectifier 220 and generates an output voltage at Vₗᵢₙ 235 that is based on the saturation current of a diode-connected FET (Mlog), FET 230. The logamp 222 may include an operational amplifier (opamp) 225. A current, Iₒᵤₜ, is drawn through the FET 230 and coupled to the negative input of the opamp 225 and the output of the opamp 225. The opamp 225 is a negative feedback connected opamp and causes Iₒᵤₜ to be converted to a linear-in-dB voltage at Vₗᵢₙ 235. The FET 230 may include the same or similar devices as that of the rectifier 220 (e.g., M1/2) to remove process and temperature variation in the signal. Because the rectifier 220 core current (and a DC component proportional to the differential RF fundamental (I_{dcrf})) are allowed to move with temperature, the first order temperature effects on the FET 230 voltage (and therefore the output voltage) are canceled. Thus, the logamp 222 may include a diode-connected transistor, and the diode-connected transistor may have one or more transistor parameters that match the pair of input transistors of one or more (e.g., each) of the rectifier cores of the rectifier 220.

The output of the logamp 222 may be connected to one or more resisters, some of which may be grounded, and input into the scaling amplifier 240. The scaling amplifier 240 may be a low-power operational amplifier that modifies the natural logamp output voltage range to a desired full-scale input range of an analog-to-digital converter that may be coupled to the Vₒᵤₜ 245.

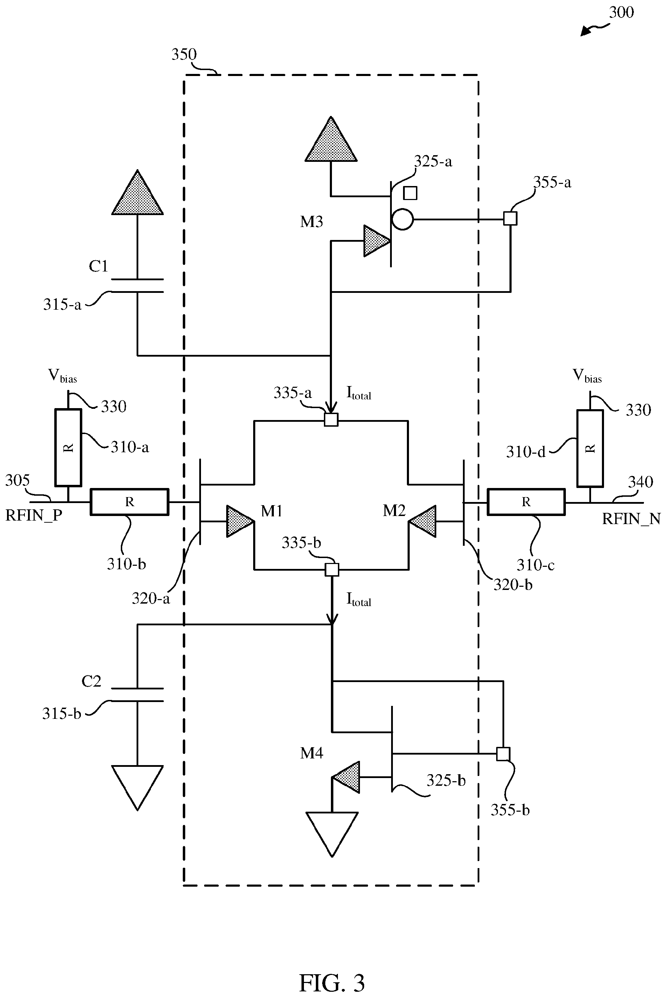

**FIG.** 3 shows an example of a rectifier stage 300 that supports low-power integrated radio frequency power detection in accordance with aspects of the present disclosure. The rectifier stage 300 may be part of an RF power detector, such as the RF power detectors 180 of FIG. 1 or FIG. 2. The rectifier stage 300 may be one of multiple (e.g., four) stages of rectifier cores in an RF power detector. In examples other than FIG. 3, the rectifier stage 300 may include different or additional components or connectivity compared with those shown in FIG. 3.

The rectifier stage 300 may include a rectifier core 350. The rectifier core 350 may include an N-type field effect transistor (NFET) differential pair M1 320-a and M2 320-b. An NFET may be an N-type or N-channel metal-oxide-semiconductor field-effect transistor (MOSFET). The NFET differential pair M1 320-a and M2 320-b may have a constant voltage biasing, V_{bias}, applied at 330-a and 330-b, which may provide a DC bias to the differential inputs RFIN_P 305 and RFIN_N 340. The source terminals of the NFET differential pair M1 320-a and M2 320-b may be coupled together (e.g., at node 335-b). The drain terminals of the NFET differential pair M1 320-a and M2 320-b may be coupled together (e.g., at node 335-a). The RF differential pair M1 320-a and M2 320-b may receive as inputs a differential RF signal input at RFIN_P 305 and RFIN_N 340.

With differential RF voltage applied to the NFET differential pair M1 320-a and M2 320-b, a net current (Iₜₒₜₐₗ) results, consisting of several components: cancelation of differential RF fundamental & odd harmonics; a DC component proportional to the differential RF fundamental (I_{dcrf}), as well as any common-mode RF fundamental, if present; unwanted differential higher (e.g., greater than or equal to two times) even-order harmonics; unwanted common mode higher harmonics, all orders; and DC bias current component I_{dcbias}.

The rectifier core 350 also includes diode-connected NFET (source) and PFET (drain) load transistors, M3 and M4, 325-a and 325-b, respectively (collectively referred to as load transistors 325). The load transistors 325 load the NFET differential pair M1 320-a and M2 320-b, and both conduct Iₜₒₜₐₗ to the differential pair, at 335-a and 335-b, respectively. A voltage may be output at node 355-a corresponding to the M3 load transistor 325-a. A voltage may be output at node 355-b corresponding to the M4 load transistor 325-b. Although only a single load transistor 325 is shown in each position (e.g., source or drain), there could be two or more load transistors (e.g., cascaded) in each position. For example, there may be two or more load transistors where the single M3 is located in FIG. 3. Likewise, there could be two or more load transistors where the single M4 is located in FIG. 3. Each of the multiple load transistors may be similarly coupled (e.g., a second load transistor cascoded with M3 may also be diode connected if M3 is diode connected).

The load transistors 325 may be shunted with capacitors C1 315-a and C2 315-b (collectively referred to herein as capacitors 315). In some examples, the capacitors C1 315-a and C2 315-b may be sized for low impedance at the two times and greater harmonics. The capacitors 315 cause the voltage at the load transistors 325 to be based only on the DC current components of I_{dcrf} and I_{dcbias}. This removes the high frequency content from the load transistors 325.

In some examples, V_{bias} and the width and length of the diode-coupled load transistors may be selected such that the total DC current with no RF applied is very small (e.g., sub-threshold) and the total DC current with a maximum RF applied does not cause the NFET differential pair M1 320-a and M2 320-b to enter the triode region due to gate-source voltage (Vgs) at M3 325-a and M4 325-b.

The DC current to the rectifier core 350 is not bias-controlled. For example, biasing voltage(s) may not be applied to the load transistors 325 of the rectifier core 350, and instead the gate voltages of the load transistors may be allowed to float. V_{bias} being constant means that M1 320-a, M2 320-b, M3 325-a, and M4 325-b are at constant V_{gsdc}. The DC bias current and I_{dcrf} will rise with higher temperatures and fall with lower temperatures. With proper device sizing and matching, this will cancel temperature effects of the logamp diode. When the device is matched, one or more parameters of the components of the rectifier cores may be the same or similar. For example, the FETs M1-M4 may be the same (e.g., having transistor parameters within a tolerance threshold).

The rectifier stage 300 may include resisters 310, including resister 310-a, resister 310-b, resister 310-c, and resister 310-d, which may isolate the RF signal input at RFIN_P 305 and RFIN_N 340 from the bias voltage V_{bias} 330. In other examples, other numbers and placements of resisters 310 may be used.

In the example of FIG. 3, a simple resistive DC bias injection is shown without RF matching. In other examples, an RF matching network may be used, and bias may be introduced as part of the RF matching network as needed. In the example of FIG. 3, the rectifier stage 300 may correspond to a first rectifier stage of an example RF power detector. In other examples, the rectifier stage 300 may have different components and connectivity, and may correspond to other stages of an RF power detector.

Although the rectifier core 350 is illustrated using NFET differential pairs, it should be understood that PFET differential pairs may also be used without deviating from the described operation of the rectifier core 350.

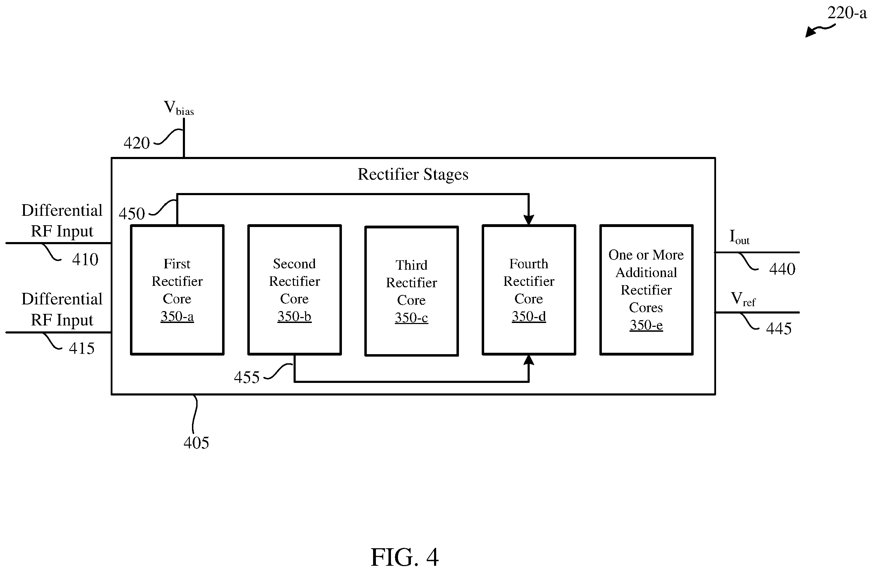

**FIG.** 4 shows an example of a rectifier 220-a that supports low-power integrated radio frequency power detection in accordance with aspects of the present disclosure. The rectifier 220-a may be an example of rectifier 220 of FIG. 2, and may be part of an RF power detector, such as the RF power detectors 180 of FIGs. 1 or 2. In examples other than FIG. 4, the rectifier 220-a may include different or additional components or connectivity compared with those shown in FIG. 4.

The rectifier 220-a may include rectifier stages 405, which each may include one or more rectifier cores 350. The rectifier cores 350 may include a first rectifier core 350-a, a second rectifier core 350-b, a third rectifier core 350-c, and a fourth rectifier core 350-d. In other examples, other numbers of rectifier cores 350 may be used. Each rectifier core 350 may be coupled to additional components in order for the respective rectified core 350 to perform its operations. The first rectifier core 350-a may perform rectification on the differential signals. The second rectifier core 350-b may determine the common mode and the DC level. The third rectifier core 350-c may determine what the bias conditions are on each of the FETs of each of the rectifier cores 350. The fourth rectifier core 350-d may determine the output current, Iₒᵤₜ 440, for the RF power detector based on the outputs of the first rectifier core 350-a and the second rectifier core 350-b. The output current, Iₒᵤₜ 440, may be proportional to the difference between the differential inputs to the rectifier 220-a and may suppress spurious tones and noise. The output current, Iₒᵤₜ 440, may be proportional to the actual RF input power, where the deleterious effects that happen due to the operation of the circuitry and temperature variations are compensated.

The rectifier 220-a may have differential RF input terminals, such as a differential RF input terminals 410 and 415, to the rectifier stages 405. The rectifier 220-a may also have a V_{bias} input 420 that is coupled with at least one of the rectifier cores 350. The rectifier stages 405 may output Iₒᵤₜ 440 and first reference voltage 445.

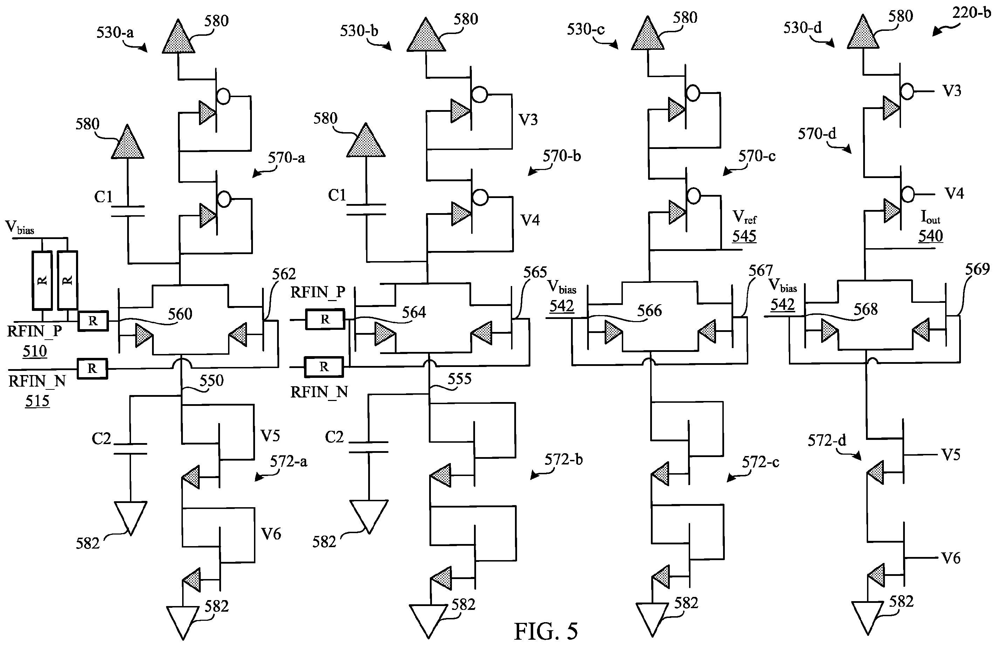

The first rectifier core 350-a may be configured to generate a first current reference 450 associated with a difference between the differential RF input terminals. For example, the first rectifier core 350-a may generate the first current reference 450 associated with the difference between the differential RF input terminals 410 and 415. The first rectifier core 350-a may have one or more capacitors such as C1 and C2 illustrated in FIG. 5 that may have capacitance selected to reduce differential harmonics (e.g., may have low impedance at harmonic frequencies to shunt harmonic components).

The second rectifier core 350-b may be configured to generate a second current reference 455 associated with a common mode of the differential RF input terminals. For example, the second rectifier core 350-b may generate the second current reference 455 associated with the common mode of the differential RF input terminals 410 and 415. The second rectifier core 350-b may have one or more capacitors such as C1 and C2 illustrated in FIG. 5 that may have capacitance selected to reduce common mode harmonics (e.g., may have low impedance at harmonic frequencies to shunt harmonic components).

The third rectifier core 350-c may be configured to generate a first reference voltage 445, V_{ref}, that is based at least in part on a bias voltage of the differential RF input terminals. For example, the third rectifier core 350-c may generate the first reference voltage 445 that is based at least in part on a bias voltage of the differential RF input terminals 410 and 415.

The fourth rectifier core 350-d may be configured to generate a rectifier output current, Iₒᵤₜ 440, that is based at least in part on the first current reference 450 and the second current reference 455. For example, the fourth rectifier core 350-d may generate a rectifier output current associated with (e.g., a function of) the first current reference and the second current reference. For example, the rectifier output current may correspond to a a current corresponding to the second current reference 455 subtracted from a current corresponding to the first current reference 450.

Each rectifier core 350 may include a pair of input transistors, one or more first load transistors coupled between a power supply and first terminals of the pair of input transistors, and one or more second load transistors coupled between second terminals of the pair of input transistors and a ground.

In some examples, the first rectifier core 350-a may include gate terminals of the pair of input transistors coupled with the differential RF input terminals 410 and 415, and may have the one or more first load transistors and the one or more second load transistors diode connected.

In some examples, the second rectifier core 350-b may include gate terminals of the pair of input transistors coupled with a common mode signal of the differential RF input terminals 410 and 415. In the second rectifier core 350-b, the one or more first load transistors and the one or more second load transistors may be diode connected.

In some examples, the third rectifier core 350-c may include gate terminals of the pair of input transistors coupled with the bias voltage of the differential RF input terminals 410 and 415. In the third rectifier core 350-c, the one or more first load transistors and the one or more second load transistors may be diode connected.

In some examples, the fourth rectifier core 350-d may include gate terminals of the pair of input transistors coupled with the bias voltage of the differential RF input terminals 410 and 415. The fourth rectifier core 350-d may have gate terminal(s) of the first load transistor(s) coupled to gate terminal(s) of the first load transistor(s) of the second rectifier core 350-b (e.g., via the second current reference 455), and have gate terminal(s) of the second load transistor(s) coupled to gate terminal(s) of the second load transistor(s) of the first rectifier core 350-a (e.g., via the first current reference 450).

In some examples, the one or more first load transistors may include at least two first load transistors. The one or more second load transistors may include at least two second load transistors.

In some examples, the rectifier 220-a may include one or more additional rectifier cores 350-e, such as a fifth rectifier core. The one or more additional rectifier cores 350-e may be configured to generate a second reference voltage that is based at least in part on the bias voltage of the differential RF input terminals, wherein the second voltage is further based at least in part on the second reference voltage. The one or more additional rectifier cores 350-e may provide additional spurious tone and error compensation. For example, a fifth rectifier core may include a log amp that is connected as a transistor instead of a diode, and error reduction may be improved.

In some examples, the rectifier 220-a may be connected to an amplifier configured to generate a second voltage that is logarithmically related to the rectifier output current, wherein the second voltage is based at least in part on the rectifier output current and the first reference voltage.

**FIG.** 5 shows an example of a rectifier 220-b that supports low-power integrated radio frequency power detection in accordance with aspects of the present disclosure. The rectifier 220-b may be part of an RF power detector, such as the RF power detector 180 of FIGs. 1 and 2. The rectifier 220-b may be an example of one or more aspects of the rectifiers 220 shown in FIGs. 2 or 4. In examples other than FIG. 5, the rectifier 220-b may include different or additional components or connectivity compared with those shown in FIGs. 3 and 4.

The rectifier 220-b may include four rectifier stages 530. The rectifier stages 530 may include a first rectifier stage 530-a, a second rectifier stage 530-b, a third rectifier stage 530-c, and a fourth rectifier stage 530-d. In other examples, other numbers of rectifier stages 30 may be used. Each rectifier stage 530 may include a rectifier core, such as the rectifier cores 350 shown in FIGs. 3 or 4.

The rectifier 220-b may have differential RF input terminals, such as a differential RF input terminals 510 and 515, to the rectifier stages 530. The rectifier 220-b may also have a V_{bias} voltage 542 that inputs to at least one of the rectifier stages 530, such as the third rectifier stage 530-c and the fourth rectifier stage 530-d. The rectifier 220-b may output Iₒᵤₜ 540 and first reference voltage 545. Each rectifier stage 530 may include a pair of input transistors, one or more first load transistors 570 coupled between a power supply 580 and first terminals of the pair of input transistors, and one or more second load transistors 572 coupled between second terminals of the pair of input transistors and a ground 582.

The first rectifier stage 530-a may be configured to generate a first current reference 550 (e.g., V5) associated with a difference between differential RF input terminals 510 and 515. In some cases, the first rectifier stage 530-a may be configured to generate multiple first current references 550 based on cascoded load transistors (e.g., V5, V6). For example, the first rectifier stage 530-a may generate the first current reference 550 associated with the difference between the differential RF input terminals 510 and 515. In some examples, the first rectifier stage 530-a may include gate terminals of the pair of input transistors 560, 562 coupled with differential RF input terminals 510 and 515. The first rectifier stage 530-a may also include one or more first load transistors 570-a and one or more second load transistors 572-a, which may be diode connected.

The second rectifier stage 530-b may be configured to generate a second current reference 555 (e.g., V4) associated with a common mode of the differential RF input terminals 510 and 515. In some cases, the second rectifier stage 530-b may be configured to generate multiple second current references 555 based on cascoded load transistors (e.g., V3, V4). For example, the second rectifier stage 530-b may generate the second current reference 555 associated with the common mode of the differential RF input terminals 510 and 515. In some examples, the second rectifier stage 530-b may include gate terminals of the pair of input transistors 564, 565 coupled with a common mode signal of the differential RF input terminals 510 and 515. The second rectifier stage 530-b may also include one or more first load transistors 570-b and one or more second load transistors 572-b, which may be diode connected.

The third rectifier stage 530-c may be configured to generate a first reference voltage 545, V_{ref}, that is based at least in part on a bias voltage of the differential RF input terminals 510 and 515. For example, the third rectifier stage 530-c may generate the first reference voltage 545 that is based at least in part on a bias voltage 542 of the differential RF input terminals 510 and 515. In some examples, the third rectifier stage 530-c may include gate terminals of the pair of input transistors 566, 567 coupled with the bias voltage 542 of the differential RF input terminals 510 and 515. The third rectifier stage 530-c may also include one or more first load transistors 570-c and one or more second load transistors 572-c, which may be diode connected.

The fourth rectifier stage 530-d may be configured to generate a rectifier output current, Iₒᵤₜ 540, that is based at least in part on the first current reference 550 and the second current reference 555. For example, the fourth rectifier stage 530-d may generate a rectifier output current, Iₒᵤₜ 540, associated with the first current reference 550 from the first rectifier stage 530-a and the second current reference 555 from the second rectifier stage 530-b. In some examples, the fourth rectifier stage 530-d may include gate terminals of the pair of input transistors 568, 569 coupled with the bias voltage 542 of the differential RF input terminals 510 and 515. The fourth rectifier stage 530-d may have a gate terminal of the first load transistor 570-d coupled to a gate terminal of the first load transistor 570-b of the second rectifier stage 530-b, and may have a gate terminal of the second load transistor 572-d coupled to a gate terminal of the second load transistor 572-a of the first rectifier stage 530-a.

Although the first load transistors 570 are illustrated as having two transistors, it should be understood that the first load transistors 570 may in some cases include a single first load transistor 570, or more than two first load transistors. Similarly, although the second load transistors 572 are illustrated as having two transistors, it should be understood that the second load transistors 572 may in some cases include a single second load transistor 572, or more than two second load transistors. The quantities of the first load transistors 570 or second load transistors 572 may be selected based on the supply voltage level, the bias voltage, or the threshold voltages of the load transistors. In some examples, the one or more first load transistors 570 may include at least two first load transistors. The one or more second load transistors 572 may include at least two second load transistors. In some examples, the quantity of the one or more first load transistors 570 may be different than the quantity of the one or more second load transistors 572.

In some examples, the rectifier 220-b may include a fifth rectifier stage configured to generate a second reference voltage that is based at least in part on the bias voltage of the differential RF input terminals, wherein the second voltage is further based at least in part on the second reference voltage. The fifth rectifier stage may compensate for any difference in drain-gate voltages between a logamp transistor and the input transistors to the third rectifier stage 530-c.

Mismatch between the rectifier stages 530 may cause nonlinearity in the RF power detector, which can cause spurious signals in the RF power detector or even collapse the fourth rectifier stage 530-d at low RF input powers. The techniques and apparatus described herein can prevent the collapse of the fourth rectifier stage 530-d and reduce spurious signals. For example, the rectifier stages 530 may implement four load transistors, P and N devices, with high device multiplicity, which allows extensive inter-digitization in the circuit layout. This may average out any effects of mismatch between the rectifier stages 530. In some examples, the fourth rectifier stage 530-d PFET (e.g., first load transistors 570-d) device multiplicity may be made programmable under digital control (e.g., the diode current curve may be subject to calibration). In some examples, the digital control may be a 4-bit or 5-bit control, although other forms of digital control may be used.

In some examples, the respective components of the first rectifier stage 530-a, the second rectifier stage 530-b, the third rectifier stage 530-c, and the fourth rectifier stage 530-d may have one or more transistor parameters that are matched with each other. As used herein, matching one or more transistor parameters means that the parameters of the one or more transistors are approximately the same, or are similar within a threshold difference of each other. In some examples, the respective components of the first rectifier stage 530-a, the second rectifier stage 530-b, the third rectifier stage 530-c, and the fourth rectifier stage 530-d may be copies of the same manufactured components. The closer the respective components of the rectifier stage 530 are, the more the linear range of the RF power detector can be extended. Likewise, when lower leakage (e.g., high voltage) devices and components are used, the more the linear range of the RF power detector can be extended. For example, the linear range of the RF power detector with relatively well-matched components may have a linear range of up to, or exceeding, 30 dB.

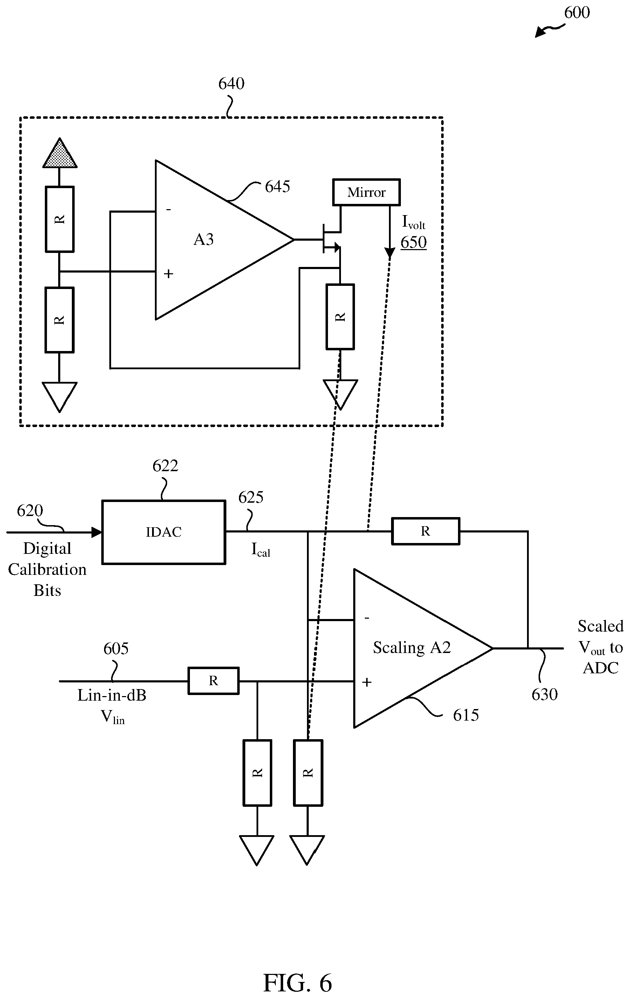

**FIG.** 6 shows an example of a scaling circuit 600 that supports low-power integrated radio frequency power detection in accordance with aspects of the present disclosure. The scaling circuit 600 may be an example of one or more aspects of an RF power detector, such as the RF power detector 180 of FIGs. 1 and 2. The scaling circuit 600 may be coupled with a power detector, such as the power detector 180 shown in FIGs. 1 or 2. In examples other than FIG. 6, the scaling circuit 600 may include different or additional components or connectivity compared with those shown in FIG. 6.

The scaling circuit 600 may include a Lin-in-dB input Vₗᵢₙ 605 to a scaling amplifier 615. The Lin-in-dB input Vₗᵢₙ 605 may be an output of an RF power detector, such as the RF power detectors 180 shown in FIGs. 1 or 2. The Lin-in-dB input Vₗᵢₙ 605 may be an example of the output Vₗᵢₙ 235 of FIG. 2. The scaling amplifier 615 may also receive an input of a calibration current 625, I_{cal}. The scaling amplifier 615 may scale the Lin-in-dB input Vₗᵢₙ 605 to a scaled Vₒᵤₜ to ADC output 630. For example, the scaling amplifier (which may be referred to as a second amplifier) may be configured to amplify a second voltage from the RF power detector to obtain an output voltage having an output range that corresponds to the input range of an analog-to-digital converter.

The scaling circuit 600 may include a calibration circuit 622 configured to output a calibration current 625, I_{cal}, to an input node of the scaling amplifier 615 (e.g., the second amplifier), wherein the calibration current 625 is based at least in part on a digital calibration bits 620 input to the calibration circuit 622. In some examples, the digital calibration bits 620 are a calibration code. The calibration circuit 622, via the calibration current 625, may calibrate the RF power detector. In some examples, the calibration circuit 622 may be a low-power current-mode DAC (IDAC). In some examples, the calibration circuit 622 may be a 4-bit DAC. In other examples, the calibration circuit 622 may be another type of digital-to-analog converter.

Some examples of the scaling circuit 600 may have a post-calibration supply voltage (e.g., VDD) sensitivity in the offset. This may be mitigated by having good supply voltage DC regulation, having V_{bias} created with a resistive divider to VDD in order to track out a portion of the variation, or by adding an additional amplifier circuit 640 which generates a constant current 650 (Iᵥₒₗₜ) proportional to the supply variation.

In some examples of the scaling circuit 600, the additional amplifier circuit 640 may be included. The additional amplifier circuit 640 may include a third amplifier 645, which may be coupled between the inputs of the scaling amplifier 615. The additional amplifier circuit 640 may input the constant current 650 into the scaling amplifier 615 similar to the process-variation calibration circuit 622. With good matching between the resistors shown in FIG. 6, no substantial additional process or temperature variations will be added.

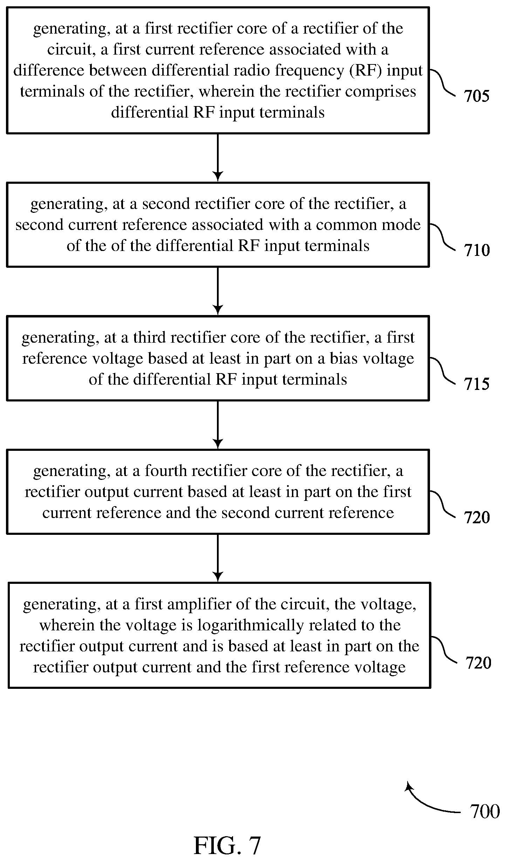

**FIG.** 7 shows a flowchart illustrating a method 700 that supports low-power integrated radio frequency power detection in accordance with aspects of the present disclosure. The operations of the method 700 may be implemented by a down converter or its components as described herein. For example, the operations of the method 700 may be performed by an RF power detector. In some examples, the down converter may execute a set of instructions to control the functional elements of the RF down converter to perform the described functions. Additionally, or alternatively, the down converter may perform aspects of the described functions using special-purpose hardware.

At 705, the method may include generating, at a first rectifier core of a rectifier of the circuit, a first current reference associated with a difference between differential RF input terminals of the rectifier, wherein the rectifier comprises differential RF input terminals. The operations of block 705 may be performed in accordance with examples as disclosed herein.

At 710, the method may include generating, at a second rectifier core of the rectifier, a second current reference associated with a common mode of the of the differential RF input terminals. The operations of block 710 may be performed in accordance with examples as disclosed herein.

At 715, the method may include generating, at a third rectifier core of the rectifier, a first reference voltage based at least in part on a bias voltage of the differential RF input terminals. The operations of block 715 may be performed in accordance with examples as disclosed herein.

At 720, the method may include generating, at a fourth rectifier core of the rectifier, a rectifier output current based at least in part on the first current reference and the second current reference. The operations of block 720 may be performed in accordance with examples as disclosed herein.

At 725, the method may include generating, at a first amplifier of the circuit, the voltage, wherein the voltage is logarithmically related to the rectifier output current and is based at least in part on the rectifier output current and the first reference voltage. The operations of block 725 may be performed in accordance with examples as disclosed herein.

In some examples, an apparatus as described herein may perform a method or methods, such as the method 700. The apparatus may include features, circuitry, logic, means, or instructions (e.g., a non-transitory computer-readable medium storing instructions executable by one or more processors), or any combination thereof for performing the following aspects of the present disclosure:
It should be noted that these methods describe examples of implementations, and that the operations and the steps may be rearranged or otherwise modified such that other implementations are possible. In some examples, aspects from two or more of the methods may be combined. For example, aspects of each of the methods may include steps or aspects of the other methods, or other steps or techniques described herein.

Information and signals described herein may be represented using any of a variety of different technologies and techniques. For example, data, instructions, commands, information, signals, bits, symbols, and chips that may be referenced throughout the description may be represented by voltages, currents, electromagnetic waves, magnetic fields or particles, optical fields or particles, or any combination thereof.

The various illustrative blocks and modules described in connection with the disclosure herein may be implemented or performed with one or more general purpose processors, a DSP, an ASIC, an FPGA, or other programmable logic device, discrete gate or transistor logic, discrete hardware components, or any combination thereof designed to perform the functions described herein. A general purpose processor may be a microprocessor, but in the alternative, the processor may be any conventional processor, controller, microcontroller, or state machine. A processor may also be implemented as a combination of computing devices (e.g., a combination of a DSP and a microprocessor, multiple microprocessors, one or more microprocessors in conjunction with a DSP core, or any other such configuration).

The functions described herein may be implemented in hardware, software executed by a processor, firmware, or any combination thereof. If implemented in software executed by a processor, the functions may be stored on or transmitted over as one or more instructions or code on a computer readable medium. Other examples and implementations are within the scope of the disclosure and appended claims. For example, due to the nature of software, functions described herein can be implemented using software executed by a processor, hardware, firmware, hardwiring, or combinations of any of these. Features implementing functions may also be physically located at various positions, including being distributed such that portions of functions are implemented at different physical locations.

Computer readable media includes both non transitory computer storage media and communication media including any medium that facilitates transfer of a computer program from one place to another. A non transitory storage medium may be any available medium that can be accessed by a general purpose or special purpose computer. By way of example, and not limitation, non transitory computer readable media may include RAM, ROM, electrically erasable programmable read-only memory (EEPROM), flash memory, compact disk read-only memory (CDROM) or other optical disk storage, magnetic disk storage or other magnetic storage devices, or any other non transitory medium that can be used to carry or store desired program code means in the form of instructions or data structures and that can be accessed by a general purpose or special purpose computer, or a general purpose or special purpose processor. Also, any connection is properly termed a computer readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, include CD, laser disc, optical disc, digital versatile disc (DVD), floppy disk and Blu ray disc where disks usually reproduce data magnetically, while discs reproduce data optically with lasers. Combinations of the above are also included within the scope of computer readable media.

As used herein, including in the claims, "or" as used in a list of items (e.g., a list of items prefaced by a phrase such as "at least one of" or "one or more of") indicates an inclusive list such that, for example, a list of at least one of A, B, or C means A or B or C or AB or AC or BC or ABC (i.e., A and B and C). Also, as used herein, the phrase "based on" shall not be construed as a reference to a closed set of conditions. For example, an exemplary step that is described as "based on condition A" may be based on both a condition A and a condition B without departing from the scope of the present disclosure. In other words, as used herein, the phrase "based on" shall be construed in the same manner as the phrase "based at least in part on."

As used herein, including in the claims, the article "a" before a noun is openended and understood to refer to "at least one" of those nouns or "one or more" of those nouns. Thus, the terms "a," "at least one," "one or more," "at least one of one or more" may be interchangeable. For example, if a claim recites "a component" that performs one or more functions, each of the individual functions may be performed by a single component or by any combination of multiple components. Thus, the term "a component" having characteristics or performing functions may refer to "at least one of one or more components" having a particular characteristic or performing a particular function. Subsequent reference to a component introduced with the article "a" using the terms "the" or "said" may refer to any or all of the one or more components. For example, a component introduced with the article "a" may be understood to mean "one or more components," and referring to "the component" subsequently in the claims may be understood to be equivalent to referring to "at least one of the one or more components." Similarly, subsequent reference to a component introduced as "one or more components" using the terms "the" or "said" may refer to any or all of the one or more components. For example, referring to "the one or more components" subsequently in the claims may be understood to be equivalent to referring to "at least one of the one or more components."

In the appended figures, similar components or features may have the same reference label. Further, various components of the same type may be distinguished by following the reference label by a dash and a second label that distinguishes among the similar components. If just the first reference label is used in the specification, the description is applicable to any one of the similar components having the same first reference label irrespective of the second reference label, or other subsequent reference label.

The description set forth herein, in connection with the appended drawings, describes example configurations and does not represent all the examples that may be implemented or that are within the scope of the claims. The term "exemplary" used herein means "serving as an example, instance, or illustration," and not "preferred" or "advantageous over other examples." The detailed description includes specific details for the purpose of providing an understanding of the described techniques. These techniques, however, may be practiced without these specific details. In some instances, well known structures and devices are shown in block diagram form in order to avoid obscuring the concepts of the described examples.

The invention is defined by the appended claims.

## Claims

1. A circuit (200), comprising:
a rectifier (220) having differential radio frequency (RF) input terminals (205, 210), the rectifier comprising:
a first rectifier core (530-a) configured to generate a first current reference (550) associated with a difference between the differential RF input terminals;
a second rectifier core (530-b) configured to generate a second current reference (555) associated with a common mode of the differential RF input terminals;
a third rectifier core (530-c) configured to generate a first reference voltage (545) that is based at least in part on a bias voltage (542) of the differential RF input terminals;
a fourth rectifier core (530-d) configured to generate a rectifier output current (540) that is based at least in part on the first current reference and the second current reference; and
an amplifier (240) configured to generate a second voltage (245) that is logarithmically related to the rectifier output current, wherein the second voltage is based at least in part on the rectifier output current and the first reference voltage.

2. The circuit of claim 1, wherein each of the first rectifier core, the second rectifier core, the third rectifier core, and the fourth rectifier core comprise:
a pair of input transistors (320-a, 320-b);
one or more first load transistors (325-a) coupled between a power supply (580) and first terminals of the pair of input transistors; and
one or more second load transistors (325-b) coupled between second terminals of the pair of input transistors and a ground (528).

3. The circuit of claim 2, wherein the first rectifier core has gate terminals of the pair of input transistors (560, 562) coupled with the differential RF input terminals, and has the one or more first load transistors and the one or more second load transistors diode connected.

4. The circuit of claim 3, wherein the second rectifier core has gate terminals of the pair of input transistors (564, 565) coupled with a common mode signal (555) of the differential RF input terminals, and has the one or more first load transistors and the one or more second load transistors diode connected.

5. The circuit of claim 4, wherein the third rectifier core has gate terminals of the pair of input transistors (566, 567) coupled with the bias voltage of the differential RF input terminals, and has the one or more first load transistors and the one or more second load transistors diode connected.

6. The circuit of claim 5, wherein the fourth rectifier core has gate terminals of the pair of input transistors (568, 569) coupled with the bias voltage of the differential RF input terminals, has a gate terminal of the first load transistor (568) coupled to a gate terminal of the first load transistor (564) of the second rectifier core, and has a gate terminal of the second load transistor (569) coupled to a gate terminal of the second load transistor (565) of the first rectifier core.

7. The circuit of any one of claims 2 through 6, wherein the one or more first load transistors comprises at least two first load transistors.

8. The circuit of any one of claims 2 through 7, wherein the one or more second load transistors comprises at least two second load transistors.

9. The circuit of any one of claims 2 through 8, wherein:
the amplifier comprises a diode-connected transistor (615), and
the diode-connected transistor has one or more transistor parameters that match the pair of input transistors of the each of the first rectifier core, the second rectifier core, the third rectifier core, and the fourth rectifier core.

10. The circuit of any one of claims 1 through 9, further comprising:
an analog-to-digital converter (622) having an input range; and
a second amplifier (645) configured to amplify the second voltage to obtain an output voltage (650) having an output range that corresponds to the input range of the analog-to-digital converter.

11. The circuit of claim 10, further comprising:
a calibration circuit (622) configured to output a current (625) to an input node of the second amplifier, wherein the current is based at least in part on a calibration code input (620) to the calibration circuit.

12. The circuit of any one of claims 1 through 11, wherein the rectifier further comprises:
a fifth rectifier core (430-e) configured to generate a second reference voltage that is based at least in part on the bias voltage of the differential RF input terminals, wherein the second voltage is further based at least in part on the second reference voltage.

13. The circuit of any one of claims 1 through 12, wherein the circuit comprises part of a complementary metal-oxide semiconductor RF integrated circuit.

14. The circuit of any one of claims 1 through 13, wherein respective components of the first rectifier core, the second rectifier core, the third rectifier core, and the fourth rectifier core have one or more transistor parameters that are matched with each other.

## Patentansprüche

1. Schaltung (200), umfassend:
einen Gleichrichter (220) mit differentiellen Funkfrequenz (RF)-Eingangsanschlüssen (205, 210), wobei der Gleichrichter Folgendes umfasst:
einen ersten Gleichrichterkern (530-a), der dazu konfiguriert ist, eine erste Stromreferenz (550) zu erzeugen, die einer Differenz zwischen den differentiellen RF-Eingangsanschlüssen zugeordnet ist;
einen zweiten Gleichrichterkern (530-b), der dazu konfiguriert ist, eine zweite Stromreferenz (555) zu erzeugen, die einem Gleichtakt der differentiellen RF-Eingangsanschlüsse zugeordnet ist;
einen dritten Gleichrichterkern (530-c), der dazu konfiguriert ist, eine erste Referenzspannung (545) zu erzeugen, die zumindest teilweise auf einer Vorspannung (542) der differentiellen RF-Eingangsanschlüsse basiert;
einen vierten Gleichrichterkern (530-d), der dazu konfiguriert ist, einen Gleichrichterausgangsstrom (540) zu erzeugen, der zumindest teilweise auf der ersten Stromreferenz und der zweiten Stromreferenz basiert; und
einen Verstärker (240), der dazu konfiguriert ist, eine zweite Spannung (245) zu erzeugen, die logarithmisch mit dem Gleichrichterausgangsstrom in Beziehung steht, wobei die zweite Spannung zumindest teilweise auf dem Gleichrichterausgangsstrom und der ersten Referenzspannung basiert.

2. Schaltung nach Anspruch 1, wobei jeder von dem ersten Gleichrichterkern, dem zweiten Gleichrichterkern, dem dritten Gleichrichterkern und dem vierten Gleichrichterkern Folgendes umfasst:
ein Paar von Eingangstransistoren (320-a, 320-b);
einen oder mehrere erste Lasttransistoren (325-a), die zwischen einer Stromversorgung (580) und ersten Anschlüssen des Paars von Eingangstransistoren gekoppelt sind; und
einen oder mehrere zweite Lasttransistoren (325-b), die zwischen zweiten Anschlüssen des Paares von Eingangstransistoren und einer Masse (528) gekoppelt sind.

3. Schaltung nach Anspruch 2, wobei der erste Gleichrichterkern Gate-Anschlüsse des Paars von Eingangstransistoren (560, 562), die mit den differentiellen RF-Eingangsanschlüssen gekoppelt sind, aufweist, und den einen oder die mehreren ersten Lasttransistoren und den einen oder die mehreren zweiten Lasttransistoren als Diode geschaltet aufweist.

4. Schaltung nach Anspruch 3, wobei der zweite Gleichrichterkern Gate-Anschlüsse des Paares von Eingangstransistoren (564, 565), die mit einem Gleichtaktsignal (555) der differentiellen RF-Eingangsanschlüsse gekoppelt sind, aufweist, und den einen oder die mehreren ersten Lasttransistoren und den einen oder die mehreren zweiten Lasttransistoren als Diode geschaltet aufweist.

5. Schaltung nach Anspruch 4, wobei der dritte Gleichrichterkern Gate-Anschlüsse des Paars von Eingangstransistoren (566, 567), die mit der Vorspannung der differentiellen RF-Eingangsanschlüsse gekoppelt sind, aufweist, und den einen oder die mehreren ersten Lasttransistoren und den einen oder die mehreren zweiten Lasttransistoren als Diode geschaltet aufweist.

6. Schaltung nach Anspruch 5, wobei der vierte Gleichrichterkern Gate-Anschlüsse des Paars von Eingangstransistoren (568, 569), die mit der Vorspannung der differentiellen RF-Eingangsanschlüsse gekoppelt sind, aufweist, einen Gate-Anschluss des ersten Lasttransistors (568), der mit einem Gate-Anschluss des ersten Lasttransistors (564) des zweiten Gleichrichterkerns gekoppelt ist, aufweist, und einen Gate-Anschluss des zweiten Lasttransistors (569), der mit einem Gate-Anschluss des zweiten Lasttransistors (565) des ersten Gleichrichterkerns gekoppelt ist, aufweist.

7. Schaltung nach einem der Ansprüche 2 bis 6, wobei der eine oder die mehreren ersten Lasttransistoren mindestens zwei erste Lasttransistoren umfassen.

8. Schaltung nach einem der Ansprüche 2 bis 7, wobei der eine oder die mehreren zweiten Lasttransistoren mindestens zwei zweite Lasttransistoren umfassen.

9. Schaltung nach einem der Ansprüche 2 bis 8, wobei:
der Verstärker einen als Diode geschalteten Transistor (615) umfasst und
der als Diode geschaltete Transistor einen oder mehrere Transistorparameter aufweist, die zu dem Paar von Eingangstransistoren von jedem von dem ersten Gleichrichterkern, dem zweiten Gleichrichterkern, dem dritten Gleichrichterkern und dem vierten Gleichrichterkern passen.

10. Schaltung nach einem der Ansprüche 1 bis 9, ferner umfassend:
einen Analog-Digital-Wandler (622) mit einem Eingangsbereich; und
einen zweiten Verstärker (645), der dazu konfiguriert ist, die zweite Spannung zu verstärken, um eine Ausgangsspannung (650) zu erhalten, die einen Ausgangsbereich aufweist, der dem Eingangsbereich des Analog-Digital-Wandlers entspricht.

11. Schaltung nach Anspruch 10, ferner umfassend:
eine Kalibrierungsschaltung (622), die dazu konfiguriert ist, einen Strom (625) an einen Eingangsknoten des zweiten Verstärkers auszugeben, wobei der Strom zumindest teilweise auf einer Kalibrierungscodeeingabe (620) an die Kalibrierungsschaltung basiert.

12. Schaltung nach einem der Ansprüche 1 bis 11, wobei der Gleichrichter ferner Folgendes umfasst:
einen fünften Gleichrichterkern (430-e), der dazu konfiguriert ist, eine zweite Referenzspannung zu erzeugen, die zumindest teilweise auf der Vorspannung der differentiellen RF-Eingangsanschlüsse basiert, wobei die zweite Spannung ferner zumindest teilweise auf der zweiten Referenzspannung basiert.

13. Schaltung nach einem der Ansprüche 1 bis 12, wobei die Schaltung einen Teil einer komplementären integrierten Metalloxid-Halbleiter-RF-Schaltung umfasst.

14. Schaltung nach einem der Ansprüche 1 bis 13, wobei jeweilige Komponenten des ersten Gleichrichterkerns, des zweiten Gleichrichterkerns, des dritten Gleichrichterkerns und des vierten Gleichrichterkerns einen oder mehrere Transistorparameter aufweisen, die zueinander passen.

## Revendications

1. Circuit (200), comprenant :
un redresseur (220) présentant des bornes d'entrée radiofréquence (RF) différentielles (205, 210), le redresseur comprenant :
un premier noyau de redresseur (530-a) conçu pour générer une première référence de courant (550) associée à une différence entre les bornes d'entrée RF différentielles ;
un deuxième noyau de redresseur (530-b) conçu pour générer une seconde référence de courant (555) associée à un mode commun des bornes d'entrée RF différentielles ;
un troisième noyau de redresseur (530-c) conçu pour générer une première tension de référence (545) qui est basée au moins en partie sur une tension de polarisation (542) des bornes d'entrée RF différentielles ;
un quatrième noyau de redresseur (530-d) conçu pour générer un courant de sortie de redresseur (540) qui est basé au moins en partie sur la première référence de courant et la seconde référence de courant ; et
un amplificateur (240) conçu pour générer une seconde tension (245) qui est logarithmiquement liée au courant de sortie du redresseur, dans lequel la seconde tension est basée au moins en partie sur le courant de sortie du redresseur et la première tension de référence.

2. Circuit de la revendication 1, dans lequel chacun du premier noyau de redresseur, du deuxième noyau de redresseur, du troisième noyau de redresseur et du quatrième noyau de redresseur comprend :
une paire de transistors d'entrée (320-a, 320-b) ;
un ou plusieurs premiers transistors de charge (325-a) couplés entre une alimentation électrique (580) et de premières bornes de la paire de transistors d'entrée ; et
un ou plusieurs seconds transistors de charge (325-b) couplés entre de secondes bornes de la paire de transistors d'entrée et une masse (528).

3. Circuit de la revendication 2, dans lequel le premier noyau de redresseur présente des bornes de grille de la paire de transistors d'entrée (560, 562) couplées aux bornes d'entrée RF différentielles, et présente les un ou plusieurs premiers transistors de charge et les un ou plusieurs seconds transistors de charge connectés en diode.

4. Circuit de la revendication 3, dans lequel le deuxième noyau de redresseur présente des bornes de grille de la paire de transistors d'entrée (564, 565) couplées à un signal de mode commun (555) des bornes d'entrée RF différentielles, et présente les un ou plusieurs premiers transistors de charge et les un ou plusieurs seconds transistors de charge connectés en diode.

5. Circuit de la revendication 4, dans lequel le troisième noyau de redresseur présente des bornes de grille de la paire de transistors d'entrée (566, 567) couplées à la tension de polarisation des bornes d'entrée RF différentielles, et présente les un ou plusieurs premiers transistors de charge et les un ou plusieurs seconds transistors de charge connectés en diode.

6. Circuit de la revendication 5, dans lequel le quatrième noyau de redresseur présente des bornes de grille de la paire de transistors d'entrée (568, 569) couplées à la tension de polarisation des bornes d'entrée RF différentielles, présente une borne de grille du premier transistor de charge (568) couplée à une borne de grille du premier transistor de charge (564) du deuxième noyau de redresseur, et présente une borne de grille du second transistor de charge (569) couplée à une borne de grille du seconde transistor de charge (565) du premier noyau de redresseur.

7. Circuit de l'une quelconque des revendications 2 à 6, dans lequel les un ou plusieurs premiers transistors de charge comprennent au moins deux premiers transistors de charge.

8. Circuit de l'une quelconque des revendications 2 à 7, dans lequel les un ou plusieurs seconds transistors de charge comprennent au moins deux seconds transistors de charge.

9. Circuit de l'une quelconque des revendications 2 à 8, dans lequel :
l'amplificateur comprend un transistor connecté en diode (615), et
le transistor connecté en diode présente un ou plusieurs paramètres de transistor qui correspondent à la paire de transistors d'entrée de chacun du premier noyau de redresseur, du deuxième noyau de redresseur, du troisième noyau de redresseur et du quatrième noyau de redresseur.

10. Circuit de l'une quelconque des revendications 1 à 9, comprenant en outre :
un convertisseur analogique-numérique (622) présentant une plage d'entrée ; et
un second amplificateur (645) conçu pour amplifier la seconde tension pour obtenir une tension de sortie (650) présentant une plage de sortie qui correspond à la plage d'entrée du convertisseur analogique-numérique.

11. Circuit de la revendication 10, comprenant en outre :
un circuit d'étalonnage (622) conçu pour délivrer un courant (625) à un nœud d'entrée du second amplificateur, dans lequel le courant est basé au moins en partie sur une entrée de code d'étalonnage (620) au circuit d'étalonnage.

12. Circuit de l'une quelconque des revendications 1 à 11, dans lequel le redresseur comprend en outre :
un cinquième noyau de redresseur (430-e) conçu pour générer une seconde tension de référence qui est basée au moins en partie sur la tension de polarisation des bornes d'entrée RF différentielles, dans lequel la seconde tension est en outre basée au moins en partie sur la seconde tension de référence.

13. Circuit de l'une quelconque des revendications 1 à 12, dans lequel le circuit comprend une partie d'un circuit intégré RF semi-conducteur d'oxyde métallique complémentaire.

14. Circuit de l'une quelconque des revendications 1 à 13, dans lequel les composants respectifs du premier noyau de redresseur, du deuxième noyau de redresseur, du troisième noyau de redresseur et du quatrième noyau de redresseur présentent un ou plusieurs paramètres de transistor qui sont adaptés les uns aux autres.
